# EUROPÄISCHE PATENTSCHRIFT

(11) **EP 4 464 131 B1**
(45) Veröffentlichungstag und Bekanntmachung des Hinweises auf die Patenterteilung: **09.09.2026**
(21) Anmeldenummer: 22844021.0
(22) Anmeldetag: 15.12.2022
(51) Int. Cl.: H05K 7/20, F28D 15/02, F28F 1/40, F28F 1/02, F28F 1/32, F28F 7/02, F28F 21/08, H10W 40/73

(54) **KÜHLKÖRPER MIT HEATPIPE FÜR EINE ELEKTRONISCHE KOMPONENTE UND EINE ENTSPRECHENDE ANORDNUNG**
COOLING BODY HAVING A HEAT PIPE FOR AN ELECTRONIC COMPONENT, AND CORRESPONDING ASSEMBLY
CORPS DE REFROIDISSEMENT AYANT UN CALODUC POUR UN COMPOSANT ÉLECTRONIQUE, ET ENSEMBLE CORRESPONDANT

(30) Priorität: 13.01.2022 DE 102022100756
(43) Veröffentlichungstag der Anmeldung: 20.11.2024
(73) Patentinhaber: Rittal GmbH & Co. KG, 35745 Herborn (DE)
(72) Erfinder: CACHO ALONSO, Juan Carlos, 38102 Braunschweig (DE)
(74) Vertreter: Angerhausen, Christoph
(86) Internationale Anmeldenummer: PCT/DE2022/100955
(87) Internationale Veröffentlichungsnummer: WO 2023/134815

(56) Entgegenhaltungen:
- EP-A1- 3 933 336
- CN-U- 212 658 104
- CN-U- 214 102 190
- US-A1- 2021 392 783

## Beschreibung

Die Erfindung geht aus von einem Kühlkörper für eine elektronische Komponente, wobei der Kühlkörper einen Luftwärmetauscher mit einer Vielzahl Lamellen aufweist, die Luftführungskanäle durch den Luftwärmetauscher begrenzen. Die US 2021/0392783 A1 offenbart einen Kühlkörper für eine elektronische Komponente, wobei der Kühlkörper einen Luftwärmetauscher mit einer Vielzahl Lamellen aufweist, die Luftführungskanäle durch den Luftwärmetauscher begrenzen, und wobei die Lamellen zumindest teilweise als Heatpipe ausgebildet sind. Die als Heatpipe ausgebildeten Lamellen sind als medienführende Hohllamellen ausgeführt, welche jeweils mindestens einen vertikalen Hohlleiter aufweisen, in dem ein Arbeitsmedium der Heatpipe geführt ist. Die Hohllamellen sind zwischen einer Verdampfungszone in einem unteren Bereich des Luftwärmetauschers und einem Hohlraum im oberen Bereich des Luftwärmetauschers ausgebildet und münden in diese. Die Hohllamellen verbinden ein Medienvolumen der Verdampfungszone mit dem Hohlraum fluidisch, sodass sämtliche Heatpipes über die Verdampfungszone und den Hohlraum fluidisch miteinander in Verbindung stehen. Weitere Kühlkörper sind in der DE 10 2004 023 037 B4, der EP 3 933 336 A1, CN 212 658 104 U und CN 214 102 190 U beschrieben.

Mit steigender Leistungsdichte elektronischer Komponenten, etwa IT-Komponenten oder Wechselrichter, sowie mit siegender Rechenleistung von Mikrochips (CPUs, GPUs) steigt auch deren Wärmeentwicklung. Die bisher verwendeten Luftwärmetauscher sind häufig als Aluminiumblöcke ausgebildet und weisen daher eine limitierte Dissipationskapazität auf. Weiterentwicklungen etwa im Bereich der Mikrochip-Technologie ermöglichen Chip-Leistungen von bis zu 400 Watt pro Chip. Aufgrund der gestiegenen Leistungsdichte sind die bekannten Luftwärmetauscher nicht mehr dazu geeignet, die entstehende Verlustleistung in ausreichendem Maße zu dissipieren. Neue Kühltechnologien wie "Direct Chip Cooling" ermöglichen es zwar, die Komponente effektiv zu kühlen. Andererseits sind diese Technologien jedoch wesentlich komplexer und vergleichsweise weniger robust gegenüber Ausfällen als zum Beispiel die in die CPU oder GPU integrierten Luftwärmetauscher. Auch die aus dem Stand der Technik bekannten Heatpipes auf Grundlage von Kupferrohren und Aluminiumlamellen weisen eine nur begrenzte Kühlkapazität auf.

Es ist daher die Aufgabe der Erfindung, einen Kühlkörper mit einem Luftwärmetauscher derart weiter zu entwickeln, dass er eine möglichst hohe Kühlleistungsdichte aufweist.

Diese Aufgabe wird durch einen Kühlkörper mit den Merkmalen des Anspruchs 1 gelöst. Der nebengeordnete Anspruch 7 betrifft eine entsprechende Anordnung. Vorteilhafte Ausführungsformen sind jeweils Gegenstand der abhängigen Ansprüche.

Demgemäß ist bei einem Kühlkörper vorgesehen, dass die Lamellen des Luftwärmetauschers zumindest teilweise als Heatpipe ausgebildet sind. Durch die Verwendung der Heatpipes wird die Verlustleistung effizient auf das Volumen des Luftwärmetauschers verteilt, wodurch der Wärmeabtausch an die den Luftwärmetauscher durchströmende Luft verbessert und damit der Wirkungsgrad des Kühlkörpers erhöht wird.

Die als Heatpipe ausgebildeten Lamellen weisen jeweils mindestens einen vertikalen Hohlleiter oder Microchannel auf, in dem ein Arbeitsmedium der Heatpipe geführt ist. Demgemäß sind die Lamellen als medienführende Hohllamellen ausgeführt . Die Hohllamellen sind zwischen einer Verdampfungszone in einem unteren Bereich des Luftwärmetauschers und einem Hohlraum im oberen Bereich des Luftwärmetauschers ausgebildet und münden in diese. Vorzugsweise können sich die Heatpipes bzw. die Lamellen parallel zueinander erstrecken. Die als Hohllamellen ausgebildeten Lamellen verbinden demgemäß das Medienvolumen der Verdampfungszone mit dem Hohlraum fluidisch, sodass sämtliche Heatpipes über die Verdampfungszone und den Hohlraum fluidisch miteinander in Verbindung stehen.

Der Luftwärmetauscher ist ein vorlauf- und rücklauffreier, Microchannel-Wärmeübertrager mit einem hermetisch gekapselten Volumen eines Arbeitsmediums. Der Luftwärmetauscher kann beispielsweise dadurch bereitgestellt werden, dass bei einem handelsüblichen Microchannel-Wärmeübertrager gegebenenfalls vorhandene Vor- und Rückläufe verschlossen werden, nachdem der Microchannel-Wärmeübertrager mit einem Arbeitsmedium, beispielsweise mit einem 2-Phasen-Kältemittel, befüllt worden ist, sodass das Arbeitsmedium in dem verschlossenen Microchannel-Wärmeübertrager hermetisch gekapselt ist.

Der Microchannel-Wärmeübertrager kann eine Vielzahl Microchannel aufweisen, die jeweils eine der Heatpipes bilden. Die Microchannel können durch die Verdampfungszone und ggf. einen oberen Hohlraum miteinander verbunden sein. Dadurch ergibt sich eine verbesserte Verteilung der Verlustleistung auf sämtliche Microchannel, wodurch die Wärmeabfuhrkapazität erhöht wird. Dies trägt ebenfalls zur Vermeidung von Hotspots in der elektronischen Komponente bei. Weiterhin kann die Verlustfläche deutlich über die Kontaktfläche der elektronischen Komponente mit dem Kühlkörper hinaus vergrößert werden.

Vorzugsweise bildet jeder Microchannel der Vielzahl Microchannel des Microchannel-Wärmeübertragers jeweils eine der Heatpipes.

Der Microchannel-Wärmeübertrager weist eine Verdampfungszone auf, in welche die Microchannel mit einem ersten Ende münden und über welche die Microchannel fluidisch miteinander verbunden sind. Die Verdampfungszone kann ein Reservoir für ein Arbeitsmittel der Heatpipes sein, welche von den Microchannel gebildet werden.

Die Verdampfungszone kann in unmittelbarem oder mittelbarem thermischem Kontakt zu einer Montageseite des Kühlkörpers für die Montage des Kühlkörpers auf einer zu kühlenden elektronischen Komponente stehen. Vorzugsweise sind die Montageseite des Kühlkörpers und übrige Bestandteile des Kühlkörpers, insbesondere die Heatpipes des Kühlkörpers, beispielsweise der die Heatpipes bereitstellende Microchannel-Wärmeübertrager, einteilig ausgebildet, vorzugsweise aus demselben Werkstoff. Ein derartiger Kühlkörper kann beispielsweise mit Hilfe eines additiven Fertigungsverfahrens, etwa mittels Auftragsschweißen, hergestellt werden. Die Einteiligkeit gewährleistet eine optimale Wärmeübertragung zwischen der Montageseite und den Heatpipes bzw. zwischen der Montageseite und der Verdampfungszone der Heatpipes. Geeignete Materialien umfassen Aluminium oder eine aluminiumhaltige Legierung.

Der Microchannel-Wärmeübertrager kann einen Hohlraum aufweisen, in welchen die Microchannel mit ihren den ersten gegenüber angeordneten zweiten Enden münden. Der Hohlraum kann Bestandteil einer Kondensationszone der Heatpipes sein. Da funktionsgemäß die Kondensation jedoch aufgrund der den Luftwärmetauscher durchsetzenden Luft entlang der als Heatpipes ausgebildeten Lamellen geschieht, bedarf der Kühlkörper nicht zwangsläufig einer separaten Kondensationszone, wie dies bei aus dem Stand der Technik bekannten Heatpipe-Anordnungen bekannt ist. Der Hohlraum kann daher insbesondere die Funktion aufweisen, die zweiten Enden der Vielzahl Heatpipes miteinander zu verbunden, um einen fluidischen Austausch zwischen den Heatpipes und damit eine Optimierung des Wirkungsgrades des Kühlkörpers durch eine bessere Verteilung der Kühllast über sein Kühlkörpervolumen zu erreichen.

Erfindungsgemäß weist der Microchannel-Wärmeübertrager zusätzlich zu den als Heatpipe ausgebildeten Lamellen weitere Lamellen auf, die sich im Wesentlichen parallel zueinander und voneinander beabstandet sowie im Wesentlichen senkrecht zu den als Heatpipe ausgebildeten Lamellen erstrecken. In der Einbausituation sind die als Heatpipe ausgebildeten Lamellen zur Gewährleistung einer optimalen Funktion der Heatpipes vertikal, oder im Wesentlichen vertikal, oder zumindest abschnittsweise vertikal ausgerichtet. Folglich können die bei der bevorzugten Ausführungsform zusätzlich vorhandenen, weiteren Lamellen in der Einbausituation im Wesentlichen horizontal ausgerichtet sein. Die weiteren Lamellen können im Wesentlichen zwei Funktionen aufweisen. Zum einen dienen die Lamellen zur Wärmeübertragung zwischen den Heatpipes und damit zur Steigerung der Effizienz des Kühlkörpers, indem eine erforderliche Kühllast besser über das Kühlkörpervolumen verteilt bzw. eine lokal in der zu kühlenden elektronischen Komponente entstehende Verlustleistung optimal abgeführt wird. Andererseits bilden die weiteren Lamellen eine zusätzliche Fläche für die Wärmeübertragung zwischen dem Kühlkörper und der den Kühlkörper durchströmenden Luft, insbesondere zwischen den Heatpipes und der den Kühlkörper durchströmenden Luft.

Die weiteren Lamellen können daher als massive Lamellen aus einem wärmeleitfähigen Material ausgebildet sein, wobei benachbarte der als Heatpipe ausgebildeten Lamellen über eine Vielzahl der weiteren Lamellen thermisch miteinander gekoppelt sind.

Die als Heatpipe ausgebildeten Lamellen können sich parallel zueinander erstrecken und einen Abstand zueinander aufweisen, der weniger als 10 mm, vorzugsweise weniger als 8 mm und besonders bevorzugt weniger als 6 mm beträgt.

Die als Heatpipe ausgebildeten Lamellen können jeweils eine Mehrzahl vertikaler und paralleler Microchannel aufweisen, die in einer Längsrichtung der als Heatpipe ausgebildeten Lamellen hintereinander angeordnet sind. Soweit hier von vertikal ausgerichteten Lamellen zur Ausbildung der Heatpipes gesprochen wird, ist dabei die Einbausituation des Kühlkörpers auf einer elektronischen Komponente beschrieben, bei welcher der Kühlkörper zur Bereitstellung einer möglichst hohen Effizienz der Heatpipes vorzugsweise derart ausgerichtet ist, dass die Heatpipes vertikal ausgerichtet sind. Dazu kann es beispielsweise erforderlich sein, dass die Heatpipes sich senkrecht zu einer Montageseite erstrecken, mit der der Kühlkörper auf einer zu kühlenden elektronischen Komponente montiert ist. Dazu kann diese, wie dies beispielsweise bei CPUs durchaus üblich ist, eine im Wesentlichen horizontale Befestigungsseite aufweisen, über welche der Kühlkörper montiert werden kann und die elektronische Komponente ihre Verlustleistung an die Umgebung abgibt.

Die als Heatpipe ausgebildeten Lamellen können jeweils eine Mehrzahl vertikaler und paralleler Microchannel aufweisen, die in einer Längsrichtung der als Heatpipe ausgebildeten Lamellen hintereinander angeordnet sind.

Gemäß einem anderen Aspekt wird eine Anordnung aus mindestens einem Kühlkörper der zuvor beschriebenen Art und einer elektronischen Komponente beschrieben, wobei der Kühlkörper in thermischem Kontakt auf der elektronischen Komponente angeordnet ist. Dabei sind die Heatpipes als vertikale Hohlleiter oder Microchannel ausgebildet bzw. weisen solche vertikale Hohlleiter oder Microchannel auf. Die vertikalen Hohlleiter oder Microchannel können sich zumindest abschnittsweise vertikal erstrecken, um eine optimale Funktionsweise der Heatpipes zu gewährleisten. Die Heatpipes können auch unter einem Winkel zur Vertikalen angeordnet sein, wobei die Funktionsweise der Heatpipe mit abnehmendem Höhenunterschied zwischen einer Verdampfungszone und einem oberen Ende, beispielsweise einer Kondensationszone, abnimmt. Analog sollten sich die Heatpipes im Wesentlichen senkrecht zu der zu kühlenden elektronischen Komponente erstrecken, um die Wärmeableitung von der elektronischen Komponente zu optimieren.

Der Kühlkörper kann mit einer Montageseite des Kühlkörpers, die eine Wärmeeinkopplungsseite einer Verdampfungszone der Heatpipes sein kann, mit der elektronischen Komponente in thermischem Kontakt stehen.

Der Kühlkörper weist an einer der Verdampfungszone gegenüberliegenden Außenseite einen Hohlraum auf, in den die vertikalen Hohlleiter oder Microchannel der Heatpipes münden, sodass über den Hohlraum ein fluidischer Übergang zwischen den Heatpipes bereitgestellt ist.

Die Anordnung kann weiterhin einen Luftstromerzeuger, beispielsweise einen Lüfter, aufweisen, mit dem Luft durch die Luftführungskanäle transportiert ist, sodass die als Heatpipe ausgebildeten Lamellen mit der Luft umströmt sind. Der Lüfter kann beispielsweise ein Radiallüfter sein.

Weitere Einzelheiten der Erfindung werden anhand der nachstehenden Figuren erläutert. Dabei zeigt:
- Figur 1: in der teilangeschnittenen perspektivischen Darstellung eine beispielhafte Ausführungsformform eines Kühlkörpers;
- Figur 2: einen horizontalen Querschnitt durch die Ausführungsform gemäß Figur 1; und
- Figur 3: eine Ausführungsform einer erfindungsgemäßen Anordnung aus einem Kühlkörper und einer IT-Komponente.

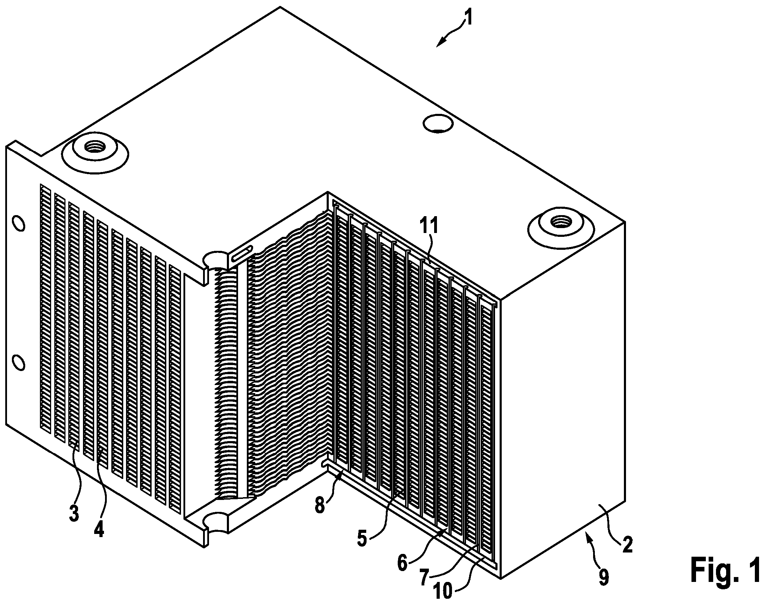

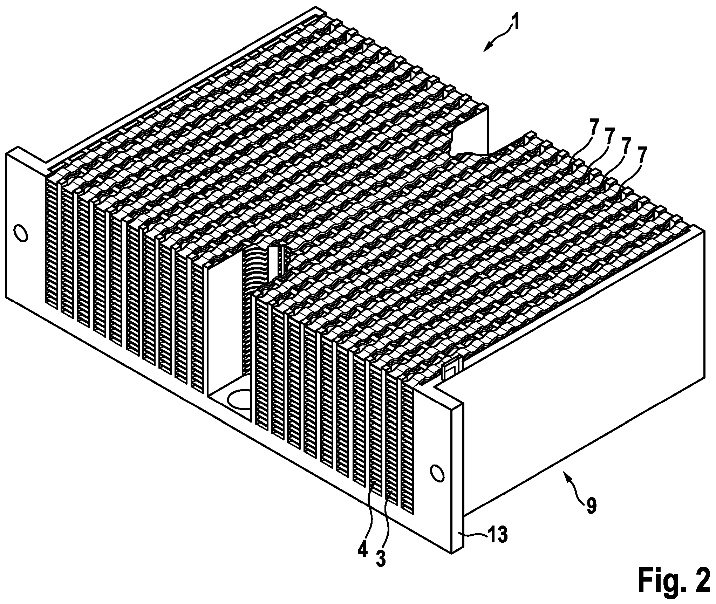

Die Figuren 1 und 2 zeigen eine erste Ausführungsform eines erfindungsgemäßen Kühlkörpers 1. Der Kühlkörper 1 kann einteilig bereitgestellt sein, beispielsweise in einem additiven Fertigungsverfahren aufgebaut sein, etwa mittels Auftragsschweißens, aus einem wärmeleitfähigen Material, vorzugsweise aus Aluminium oder Aluminiumlegierung. Die aus dem Stand der Technik bekannten additiven Verfahren sind insbesondere dazu geeignet, die feinen Strukturen nach Art eines Microchannel-Wärmeübertragers, der wesentliche Bestandteil der Ausführungsform des Kühlkörpers 1 gemäß Figur 1 ist, auszubilden.

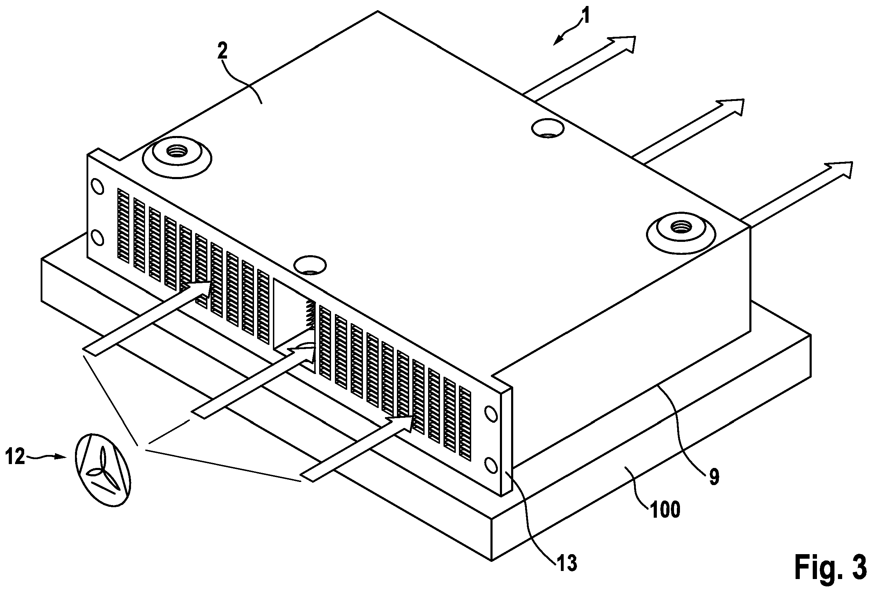

Demgemäß weist der Kühlkörper 1 einen Luftwärmetauscher 2 mit einer Vielzahl Lamellen 3, 4 auf, die Luftführungskanäle 5 durch den Luftwärmetauscher 2 begrenzen, wie dies grundsätzlich bei aus dem Stand der Technik bekannten Kühlkörpern für IT-Komponenten bekannt ist. Der erfindungsgemäße Kühlkörper zeichnet sich dadurch aus, dass die Lamellen 3, 4 zumindest teilweise als Heatpipe 6 ausgebildet sind. Vorliegend sind die in der Darstellung vertikalen Lamellen 3 als Hohlleiter oder Microcannel 7 ausgebildet, in denen ein Arbeitsmedium 8 der Heatpipe 6 geführt ist. Im Sockelbereich weist der Kühlkörper 1 eine Montageseite 9 auf, über die der Kühlkörper 1 auf einer zu kühlenden IT-Komponente (nicht dargestellt, vgl. Figur 3, dort IT-Komponente 100) montiert werden kann. Die von der zu kühlenden IT-Komponente dissipierte Verlustleistung kann über die Montageseite 9 unmittelbar in die Verdampfungszone 10 der Heatpipes 6 eingekoppelt werden. Über die Verdampfungszone stehen sämtliche Heatpipes 6 fluidisch miteinander in Verbindung, sodass selbst bei lokal auftretender Wärmekopplung in die Montageseite, welche von der Geometrie und Bauart der zu kühlenden IT-Komponente abhängen kann, eine optimale Verteilung der Verlustleistung über die Montageseite 9 bzw. die Verdampfungszone 10 erfolgt und damit die Heatpipes 6 gleichermaßen oder annähernd in gleicher Weise beaufschlagt werden und folglich zur Abführung der Verlustleistung beitragen können.

Die als Hohlleiter oder Microchannel 7 ausgebildeten Lamellen 3 sind im Wesentlichen vertikal ausgerichtet und parallel zueinander beabstandet, wobei die vertikalen Lamellen 3 einen Abstand von weniger als 10 mm aufweisen können. Aufgrund der hohen Packungsdichte der vertikalen Lamellen 3 und damit der Heatpipes, kann bei vergleichsweise geringem Bauvolumen des Kühlkörpers 1 eine hohe Kühlleistung bereitgestellt werden. Benachbarte vertikale Lamellen 3 sind über weitere horizontal ausgerichtete massive Lamellen 4 miteinander verbunden und aufgrund der guten thermischen Leitfähigkeit sowohl der vertikalen Lamellen 3 als auch der weiteren horizontalen Lamellen 4 kann bei einem den Kühlkörper 1 durchsetzenden Luftstrom ein optimaler Wärmeabtausch zwischen den Heatpipes und dem Luftstrom erfolgen. Die Horizontallamellen 4 erhöhen somit nicht nur die für die Wärmeübertragung effektive Wirkungsfläche zwischen Luft und Kühlkörper 1, sondern sie dienen auch zur Wärmeübertragung und damit zum Lastausgleich zwischen den Heatpipes.

An einer oberen horizontalen Außenseite des Kühlkörpers 1, welche an einer der Montageseite 9 gegenüberliegenden Seite des Kühlkörpers 1 angeordnet ist, ist ein Hohlraum 11 ausgebildet, über den die der Verdampfungszone 10 gegenüberliegenden Enden der Heatpipes 6 fluidisch miteinander in Verbindung stehen, wodurch auch ein fluidischer Übergang zwischen den Heatpipes 6 im Bereich einer Kondensationszone der Heatpipes 6 bereitgestellt ist. Prinzipbedingt ist dieser Hohlraum 11, insbesondere eine die Heatpipe 6 miteinander verbindende Kondensationszone, nicht zwingend erforderlich. Dies hängt damit zusammen, dass die Heatpipe 6 aufgrund ihrer Ausbildung als Microchannel in den Vertikallamellen 3 über ihre gesamte Länge von dem den Kühlkörper 1 durchsetzenden Luftstrom beaufschlagt werden und somit eine im Wesentlichen über ihre gesamte vertikale Länge verteilte Kondensationszone aufweisen.

Die Figur 2 veranschaulicht, dass der Kühlkörper 1, insbesondere dessen Luftwärmetauscher 2, nach dem Prinzip eines Microchannel-Wärmeübertragers ausgebildet ist, bei dem die sich in Luftströmungsrichtung durch den Wärmetauscher über die gesamte Tiefe des Kühlkörpers 1 erstreckenden vertikalen Lamellen 3 eine Vielzahl von unmittelbar aneinandergrenzender, jedoch fluidisch voneinander getrennter Microchannel 7 aufweisen, welche jeweils eine Heatpipe bilden, sodass jede Lamelle 3 tatsächlich eine Vielzahl Heatpipes aufweist.

Die Ausführungsform gemäß Figur 3 zeigt eine Anordnung aus einer weiteren Ausführungsform eines Kühlkörpers 1, der auf einer zu kühlenden IT-Komponente 100, beispielsweise auf einem CPU-Chipsatz, über seine Montageseite 9 montiert ist. Ein Radiallüfter 12 ist dazu eingerichtet, einen Luftvolumenstrom zu erzeugen, welcher den Kühlkörper 1 in Pfeilrichtung durchsetzt. Der Radiallüfter 12 kann über einen Montageflansch 13 an dem Luftwärmetauscher 2 montiert sein.

### Bezugszeichenliste

- 1: Kühlkörper
- 2: Luftwärmetauscher
- 3: Lamelle
- 4: Weitere Lamelle
- 5: Luftführungskanal
- 6: Heatpipe
- 7: Microchannel
- 8: Arbeitsmedium
- 9: Montageseite
- 10: Verdampfungszone
- 11: Hohlraum
- 12: Luftstromerzeuger
- 100: elektronische Komponente

## Patentansprüche

1. Kühlkörper (1) für eine elektronische Komponente (100), wobei der Kühlkörper (1) einen vorlauf- und rücklauffreien Microchannel-Wärmeübertrager (2) mit einem hermetisch gekapselten Volumen eines Arbeitsmediums (8) und mit einer Vielzahl Lamellen (3, 4) aufweist, die Luftführungskanäle (5) durch den Microchannel-Wärmeübertrager (2) begrenzen,
wobei die Lamellen (3, 4) zumindest teilweise als Heatpipe (6) ausgebildet sind, wobei die als Heatpipe (6) ausgebildeten Lamellen (3, 4) als medienführende Hohllamellen (3, 4) ausgeführt sind, welche jeweils mindestens einen vertikalen Hohlleiter oder Microchannel (7) aufweisen, in dem ein Arbeitsmedium (8) der Heatpipe (6) geführt ist, wobei
die Hohllamellen (3, 4) zwischen einer Verdampfungszone (10) in einem unteren Bereich des Microchannel-Wärmeübertragers (2) und einem Hohlraum (11) im oberen Bereich des Microchannel-Wärmeübertragers (2) ausgebildet sind und in diese münden,
wobei die Hohllamellen (3, 4) ein Medienvolumen der Verdampfungszone (10) mit dem Hohlraum (11) fluidisch verbinden, sodass sämtliche Heatpipes (6) über die Verdampfungszone (10) und den Hohlraum (11) fluidisch miteinander in Verbindung stehen,
wobei der Microchannel-Wärmeübertrager zusätzlich zu den als Heatpipe (6) ausgebildeten Lamellen (3) weitere Lamellen (4) aufweist, die sich im Wesentlichen parallel zueinander und voneinander beabstandet sowie im Wesentlichen senkrecht zu den als Heatpipe (6) ausgebildeten Lamellen (3) erstrecken.

2. Kühlkörper (1) nach Anspruch 1, bei dem die Verdampfungszone (10) in thermischem Kontakt zu einer Montageseite (9) des Kühlkörpers (1) für die Montage des Kühlkörpers (1) auf einer zu kühlenden elektronischen Komponente (100) steht.

3. Kühlkörper (1) nach einem der Ansprüche 1 bis 2, bei dem der Microchannel-Wärmeübertrager einen Hohlraum (11) aufweist, in welchen die Microchannel (7) mit ihren den ersten gegenüber angeordneten zweiten Enden münden.

4. Kühlkörper (1) nach Anspruch 1, bei dem die weiteren Lamellen (4) als massive Lamellen aus einem wärmeleitfähigen Material ausgebildet sind, wobei benachbarte der als Heatpipe (6) ausgebildeten Lamellen (3) über eine Vielzahl der weiteren Lamellen (4) thermisch miteinander gekoppelt sind.

5. Kühlkörper (1) nach einem der vorangegangenen Ansprüche, bei dem sich die als Heatpipe (6) ausgebildeten Lamellen (3) parallel zueinander erstrecken und einen Abstand zueinander aufweisen, der weniger als 10 mm, vorzugsweise weniger als 8 mm und besonders bevorzugt weniger als 6 mm beträgt.

6. Kühlkörper (1) nach einem der vorangegangenen Ansprüche, bei dem die als Heatpipe (6) ausgebildeten Lamellen (3) jeweils eine Mehrzahl vertikaler und paralleler Microchannel (7) aufweisen, die in einer Längsrichtung der als Heatpipe (6) ausgebildeten Lamellen (3) hintereinander angeordnet sind.

7. Anordnung aus mindestens einem Kühlkörper (1) nach einem der vorangegangenen Ansprüche und einer elektronischen Komponente (100), wobei der Kühlkörper (1) in thermischem Kontakt auf der elektronischen Komponente (100) angeordnet ist, wobei sich die vertikalen Hohlleiter oder Microchannel (7) der Heatpipes (6) zumindest abschnittsweise vertikal und senkrecht zu der elektronischen Komponente (100) erstrecken.

8. Anordnung nach Anspruch 7, bei der der Kühlkörper (1) mit einer Montageseite des Kühlkörpers (1), die eine Wärmeeinkopplungsseite einer Verdampfungszone (10) der Heatpipes (6) ist, mit der elektronischen Komponente (100) in thermischem Kontakt steht.

9. Anordnung nach einem der Ansprüche 7 bis 8, die einen Luftstromerzeuger (12), vorzugsweise einen Lüfter, aufweist, mit dem Luft durch die Luftführungskanäle (5) transportiert ist, sodass die als Heatpipe (6) ausgebildeten Lamellen (3, 4) mit der Luft umströmt sind.

## Claims

1. Heat sink (1) for an electronic component (100), wherein the heat sink (1) has supply- and return-line-free microchannel heat exchanger (2) with a hermetically encapsulated volume of a working medium (8) and with a multiplicity of fins (3, 4) which delimit air guide channels (5) through the microchannel heat exchanger (2),
wherein the fins (3, 4) are at least partially in the form of heat pipes (6), wherein the fins (3, 4) in the form of heat pipes (6) are in the form of fluid-carrying hollow fins (3, 4) which each have at least one vertical hollow conduit or microchannel (7) in which a working medium (8) of the heat pipes (6) is guided, wherein
the hollow fins (3, 4) are formed between an evaporation zone (10) in a lower region of the microchannel heat exchanger (2) and a cavity (11) in the upper region of the microchannel heat exchanger (2) and open into the latter, wherein the hollow fins (3, 4) fluidically connect a fluid volume of the evaporation zone (10) to the cavity (11), such that all the heat pipes (6) are fluidically connected to one another via the evaporation zone (10) and the cavity (11),
wherein the microchannel heat exchanger has, in addition to the fins (3) in the form of heat pipes (6), further fins (4) which extend substantially parallel to one another and at a distance from one another and substantially perpendicularly to the fins (3) in the form of heat pipes (6).

2. Heat sink (1) according to claim 1, in which the evaporation zone (10) is in thermal contact with a mounting side (9) of the heat sink (1) for mounting the heat sink (1) on an electronic component (100) to be cooled.

3. Heat sink (1) according to either claim 1 or claim 2, in which the microchannel heat exchanger has a cavity (11) into which the microchannels (7) open with their second ends arranged opposite the first ends.

4. Heat sink (1) according to claim 1, in which the further fins (4) are in the form of solid fins made of a thermally conductive material, wherein adjacent fins (3) in the form of heat pipes (6) are thermally coupled to one another via a multiplicity of the further fins (4).

5. Heat sink (1) according to any of the preceding claims, in which the fins (3) in the form of heat pipes (6) extend parallel to one another and are at a distance from one another which is less than 10 mm, preferably less than 8 mm and particularly preferably less than 6 mm.

6. Heat sink (1) according to any of the preceding claims, in which the fins (3) in the form of heat pipes (6) each have a multiplicity of vertical and parallel microchannels (7) which are arranged one behind the other in a longitudinal direction of the fins (3) in the form of heat pipes (6).

7. Arrangement of at least one heat sink (1) according to any of the preceding claims and an electronic component (100), wherein the heat sink (1) is arranged in thermal contact on the electronic component (100), wherein the vertical hollow conduits or microchannels (7) of the heat pipes (6) extend vertically and perpendicularly to the electronic component (100) at least in sections.

8. Arrangement according to claim 7, in which the heat sink (1) is in thermal contact with the electronic component (100) by way of a mounting side of the heat sink (1) which is a heat input side of an evaporation zone (10) of the heat pipes (6).

9. Arrangement according to any of claims 7 to 8, which has an air flow generator (12), preferably a fan, by way of which air is transported through the air-guiding channels (5), such that the air flows around the fins (3, 4) in the form of heat pipes (6).

## Revendications

1. Corps de refroidissement (1) pour un composant électronique (100), le corps de refroidissement (1) présentant un échangeur de chaleur à microcanaux (2) sans aller et sans retour avec un volume encapsulé hermétiquement d'un fluide de travail (8) et avec une pluralité de lamelles (3, 4) qui délimitent des canaux de guidage d'air (5) à travers l'échangeur de chaleur à microcanaux (2),
les lamelles (3, 4) étant réalisées au moins en partie sous forme de caloducs (6),
les lamelles (3, 4) réalisées sous forme de caloducs (6) étant réalisées sous forme de lamelles creuses (3, 4) guidant un fluide, lesquelles présentent à chaque fois au moins un guide d'ondes vertical ou un microcanal (7) dans lequel est guidé un fluide de travail (8) du caloduc (6),
les lamelles creuses (3, 4) étant réalisées entre une zone d'évaporation (10) dans une région inférieure de l'échangeur de chaleur à microcanaux (2) et une cavité (11) dans la région supérieure de l'échangeur de chaleur à microcanaux (2) et débouchant dans celles-ci,
les lamelles creuses (3, 4) reliant fluidiquement un volume de fluide de la zone d'évaporation (10) à la cavité (11) de sorte que tous les caloducs (6) soient en liaison fluidique les uns avec les autres par le biais de la zone d'évaporation (10) et de la cavité (11),
l'échangeur de chaleur à microcanaux présentant, en plus des lamelles (3) réalisées sous forme de caloducs (6), d'autres lamelles (4) qui s'étendent sensiblement parallèlement les unes aux autres et à distance les unes des autres ainsi que sensiblement perpendiculairement aux lamelles (3) réalisées sous forme de caloducs (6).

2. Corps de refroidissement (1) selon la revendication 1, dans lequel la zone d'évaporation (10) est en contact thermique avec un côté de montage (9) du corps de refroidissement (1) pour le montage du corps de refroidissement (1) sur un composant électronique (100) à refroidir.

3. Corps de refroidissement (1) selon l'une quelconque des revendications 1 à 2, dans lequel l'échangeur de chaleur à microcanaux présente une cavité (11) dans laquelle débouchent les microcanaux (7) avec leurs deuxièmes extrémités disposées à l'opposé des premières.

4. Corps de refroidissement (1) selon la revendication 1, dans lequel les lamelles supplémentaires (4) sont réalisées sous forme de lamelles massives en un matériau thermoconducteur, des lamelles voisines (3) réalisées sous forme de caloducs (6) étant couplées thermiquement les unes aux autres par le biais d'une pluralité des lamelles supplémentaires (4).

5. Corps de refroidissement (1) selon l'une quelconque des revendications précédentes, dans lequel les lamelles (3) réalisées sous forme de caloducs (6) s'étendent parallèlement les unes aux autres et présentent une distance les unes par rapport aux autres qui est inférieure à 10 mm, de préférence inférieure à 8 mm et de manière particulièrement préférée inférieure à 6 mm.

6. Corps de refroidissement (1) selon l'une quelconque des revendications précédentes, dans lequel les lamelles (3) réalisées sous forme de caloducs (6) présentent à chaque fois une pluralité de microcanaux (7) verticaux et parallèles qui sont disposés les uns derrière les autres dans une direction longitudinale des lamelles (3) réalisées sous forme de caloducs (6).

7. Agencement constitué d'au moins un corps de refroidissement (1) selon l'une quelconque des revendications précédentes et d'un composant électronique (100), le corps de refroidissement (1) étant disposé en contact thermique sur le composant électronique (100), les guides d'ondes verticaux ou les microcanaux (7) des caloducs (6) s'étendant au moins en partie verticalement et perpendiculairement au composant électronique (100).

8. Agencement selon la revendication 7, dans lequel le corps de refroidissement (1) est en contact thermique avec un côté de montage du corps de refroidissement (1), qui est un côté de couplage de chaleur d'une zone d'évaporation (10) des caloducs (6), avec le composant électronique (100).

9. Agencement selon l'une quelconque des revendications 7 à 8, qui présente un générateur de flux d'air (12), de préférence un ventilateur, avec lequel de l'air est transporté à travers les canaux de guidage d'air (5) de sorte que l'air circule autour des lamelles (3, 4) réalisées sous forme de caloducs (6).
